# FASCICULE DE BREVET EUROPEEN

(11) **EP 1 883 112 B1**
(45) Date de publication et mention de la délivrance du brevet: **01.07.2015**
(21) Numéro de dépôt: 07112649.4
(22) Date de dépôt: 17.07.2007
(51) Int. Cl.: H01L 27/146

(54) **Capteur d'images éclairé par la face arrière à température de substrat uniforme**
Bildsensor, der von der Rückseite beleuchtet wird mit einheitlicher Substrattemperatur
Back illuminated image sensor with an uniform substrate temperature

(30) Priorité: 24.07.2006 FR 0653082
(43) Date de publication de la demande: 30.01.2008
(73) Titulaire: STMICROELECTRONICS S.A., 92120 Montrouge (FR); Commissariat à l'Énergie Atomique et aux Énergies Alternatives, 75015 Paris (FR); STMicroelectronics (Crolles 2) SAS, 38920 Crolles (FR)
(72) Inventeur: Cazaux, Yvon, 38100, Grenoble (FR); Coronel, Philippe, 38530, Barraux (FR); Fenouillet-Béranger, Claire, 38100, Grenoble (FR); Roy, François, 38180, Seyssins (FR)
(74) Mandataire: de Beaumont, Michel

(56) Documents cités:
- EP-A- 1 653 515
- US-A1- 2005 227 403
- US-A1- 2006 094 151

## Description

### Domaine de l'invention

La présente invention concerne un capteur d'images réalisé sous forme monolithique destiné à être utilisé dans des dispositifs de prise de vue tels que, par exemple, des caméras, des caméscopes, des téléphones portables ou encore des appareils photographiques numériques.

### Exposé de l'art antérieur

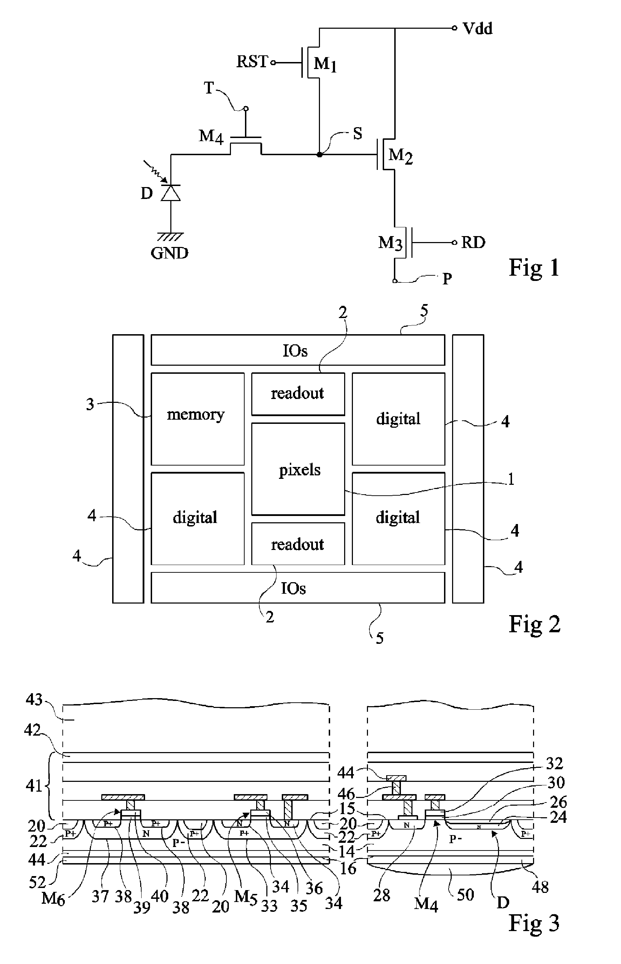

La figure 1 illustre schématiquement un exemple de circuit d'une cellule photosensible d'une matrice de cellules photosensibles d'un capteur d'images. A chaque cellule photosensible de la matrice sont associés un dispositif de précharge et un dispositif de lecture. Le dispositif de précharge est constitué d'un transistor MOS à canal N M₁, interposé entre un rail d'alimentation Vdd et un noeud de lecture S. La grille du transistor de précharge M₁ est propre à recevoir un signal de commande de précharge RST. Le dispositif de lecture est constitué de la connexion en série de premier et second transistors MOS à canal N M₂, M₃. Le drain du premier transistor de lecture M₂ est connecté au rail d'alimentation Vdd. La source du second transistor de lecture M₃ est connectée à une borne d'entrée P d'un circuit de traitement (non représenté). La grille du premier transistor de lecture M₂ est reliée au noeud de lecture S. La grille du deuxième transistor de lecture M₃ est propre à recevoir un signal de lecture RD. La cellule photosensible comprend une photodiode D dont l'anode est reliée à une source d'un potentiel de référence GND, par exemple la masse du circuit, et dont la cathode est reliée au noeud S par l'intermédiaire d'un transistor MOS à canal N de transfert de charges M₄. La grille du transistor de transfert M₄ est propre à recevoir un signal de commande de transfert de charges T. De façon générale, les signaux RD, RST, et T sont fournis par des circuits de commande non représentés en figure 1 et peuvent être fournis à l'ensemble des cellules photosensibles d'une même rangée de la matrice de cellules. Le noeud S joue le rôle d'une région de stockage de charges, la capacité apparente au noeud de lecture S étant constituée des capacités des sources des transistors M₁ et M₄, de la capacité d'entrée du transistor M₂ ainsi que de l'ensemble des capacités parasites présentes au noeud S. Selon une variante, on peut prévoir une diode spécifique dont la cathode est reliée au noeud S et dont l'anode est reliée à la masse.

Le fonctionnement de ce circuit va maintenant être décrit. Un cycle de photodétection commence par une phase de précharge pendant laquelle on impose au noeud de lecture S un niveau de tension de référence. Cette précharge s'effectue en rendant passant le transistor de précharge M₁. Une fois la précharge effectuée, le transistor de précharge M₁ est bloqué. On lit alors l'état de charge de référence au noeud S. Le cycle se poursuit par un transfert vers le noeud S des charges photogénérées, c'est-à-dire créées et stockées en présence d'un rayonnement, dans la photodiode D. Ce transfert s'effectue en rendant passant le transistor de transfert M₄. Le transfert fini, le transistor M₄ est bloqué et la photodiode D recommence à photogénérer et à stocker des charges qui seront ultérieurement transférées vers le noeud S. Simultanément, à la fin du transfert, on lit le nouvel état de charge au noeud S. Le signal de sortie transmis à la borne P dépend alors du pincement du canal du premier transistor de lecture M₂, qui est directement fonction de la charge stockée dans la photodiode.

La figure 2 représente une vue schématique de dessus d'un capteur d'images réalisé sous forme monolithique. La figure 2 illustre un exemple classique de répartition des composants électroniques (photodiodes et transistors) associés au capteur d'images. Les transistors et les photodiodes associés aux cellules photosensibles sont généralement réalisés au centre du capteur d'images au niveau du bloc 1 (pixels). Tout autour du bloc 1 sont réalisés les transistors des circuits périphériques qui, de façon générale, réalisent divers traitements des signaux associés aux cellules photosensibles. A titre d'exemple, les blocs 2 (readout) correspondent aux circuits dédiés à la fourniture des signaux de commande de la matrice de cellules photosensibles et à la lecture des signaux fournis par les cellules photosensibles (notamment les circuits de traitement précédemment mentionnés). De façon générale, d'autres circuits périphériques peuvent être prévus pour réaliser des fonctions supplémentaires directement au niveau du capteur d'images, telles que, par exemple, la correction de défauts des signaux lus aux noeuds de lecture des cellules photosensibles, la mémorisation d'images, des opérations de traitement du signal, etc. Ainsi, le bloc 3 (memory) peut correspondre à des circuits périphériques dédiés à la mémorisation d'images. Les blocs 4 (digital) peuvent correspondre à des circuits périphériques dédiés à la réalisation d'opérations de traitement du signal. Les blocs 5 peuvent correspondre aux circuits périphériques dédiés au traitement de signaux d'interface entrée/sortie, et comprennent notamment des transistors qui sont directement reliés aux plots de connexion du capteur d'images.

De façon classique, les composants électroniques du capteur d'images sont réalisés au niveau d'un substrat d'un matériau semiconducteur, par exemple une plaquette de silicium, recouvert d'un empilement de couches isolantes au niveau duquel sont formés les pistes et vias conducteurs permettant la connexion des composants électroniques du capteur d'images. L'empilement de couches isolantes est recouvert, au moins en partie centrale, de filtres colorés et de lentilles associés aux cellules photosensibles, les filtres colorés pouvant ne pas être présents lorsque le capteur d'images est un capteur noir et blanc. Un tel capteur d'images est dit éclairé par la face avant.

Un inconvénient d'un capteur d'images éclairé par la face avant est que le parcours en ligne droite des rayons lumineux depuis chaque lentille jusqu'à la photodiode de la cellule photosensible associée peut être gêné par les pistes et les vias conducteurs présents au niveau de l'empilement de couches isolantes recouvrant le substrat. Il peut alors être nécessaire de prévoir des dispositifs optiques supplémentaires, en plus des lentilles précédemment mentionnées, pour assurer que la majorité des rayons lumineux qui atteignent la face avant du capteur d'images parviennent jusqu'aux photodiodes des cellules photosensibles. On aboutit alors à des capteurs d'images pouvant avoir une structure relativement complexe difficile à réaliser.

Une solution pour éviter l'utilisation de dispositifs optiques supplémentaires et/ou pour améliorer l'absorption de la lumière au niveau du substrat du capteur d'images consiste à éclairer le capteur d'images par la face arrière du substrat au niveau duquel sont formées les photodiodes. Le capteur d'images est alors dit éclairé par la face arrière.

La figure 3 représente un exemple de réalisation classique sous forme monolithique d'un capteur d'images éclairé par la face arrière. En partie droite, on a représenté la photodiode D et le transistor M₄ d'une cellule photosensible du capteur d'images et, en partie gauche, on a représenté deux transistors MOS M₅ et M₆ associés aux circuits périphériques du capteur d'images. Le capteur d'images comprend un substrat 14 de type P faiblement dopé (P⁻) comprenant une face avant 15 et une face arrière 16. La cellule photosensible et les transistors des circuits périphériques sont, à titre d'exemple, délimités par des régions d'isolement de champ 20, par exemple en oxyde de silicium, entourées chacune d'une région 22 de type P plus fortement dopée que le substrat 14 (P⁺). La photodiode D comprend une région 24 de type N formée dans le substrat 14. Dans le cas où on utilise des photodiodes du type complètement déplété ou déserté, la région 24 est recouverte d'une région 26 de type P plus fortement dopée que le substrat 14. Une région 28 de type N, formée dans le substrat 14, correspond à la région de drain du transistor M₄. Une portion isolante 30 s'étend sur la face avant 16 du substrat 14, entre les régions 28 et 24 et correspond à l'oxyde de grille du transistor M₄. La portion isolante 30 est recouverte d'une portion de silicium polycristallin 32 correspondant à la grille du transistor M₄. Un caisson 33, formé dans le substrat 14, de type P plus fortement dopé que le substrat 14 (P⁺) correspond au caisson du transistor M₅. Deux régions de type N 34, formées dans le caisson 33, correspondent aux bornes de puissance du transistor M₅. Une portion isolante 35 s'étend entre les régions 34 et correspond à l'oxyde de grille du transistor M₅. Une portion de silicium polycristallin 36 recouvre la portion isolante 35 et correspond à la grille du transistor M₅. Un caisson 37 de type N, formé dans le substrat 14, correspond au caisson du transistor M₆. Deux régions de type P 38, formées dans le caisson 37, correspondent aux bornes de puissance du transistor M₆. Une portion isolante 39 s'étend entre les régions 38 et correspond à l'oxyde de grille du transistor M₆. Une portion de silicium polycristallin 40 recouvre la région isolante 39 et correspond à la grille du transistor M₆.

Le substrat 14 est recouvert d'un empilement de couches isolantes 41 au niveau duquel sont formées des pistes métalliques 44 de différents niveaux de métallisation et des vias métalliques 46 permettant la connexion des composants des cellules photosensibles et des circuits périphériques. L'empilement 41 est recouvert d'une couche isolante 42. Un renfort 43, correspondant par exemple à une plaquette de silicium massif, recouvre la couche isolante 42. Une implantation de type P 44 plus fortement dopée que le substrat est réalisée du côté de la face arrière 16 du substrat 14. Lorsque le capteur d'images est un capteur couleur, on prévoit, pour chaque cellule photosensible, un filtre coloré 48 recouvert d'une lentille 50 du côté de la face arrière 16 du substrat 14. Au niveau des circuits périphériques, une couche isolante 52 recouvre la face arrière 16 du substrat 14.

Un capteur d'images éclairé par la face arrière présente l'avantage que les parcours des rayons lumineux qui atteignent le capteur du côté de la face arrière 16 ne sont pas gênés par les pistes et vias métalliques 44, 46 prévus au niveau de l'empilement de couches isolantes 41.

Parmi les circuits périphériques, certains présentent une forte dissipation thermique. Il s'agit, par exemple, des circuits de génération des alimentations, des étages de sortie haute fréquence, des boucles à verrouillage de phase, etc. Un inconvénient est qu'un capteur d'images est très sensible à la température. En effet, le principe de fonctionnement du capteur d'images correspond à l'absorption de photons dans le substrat 14 qui entraîne la génération de paires électron/trou, les électrons étant capturés par les photodiodes des cellules photosensibles. Toutefois, des électrons d'origine thermique sont également susceptibles d'être capturés par les photodiodes. Ceci se traduit par l'apparition d'un bruit d'origine thermique au niveau des signaux mesurés au noeud de lecture d'une cellule photosensible qu'on appelle généralement "courant d'obscurité". Lorsqu'il est présent, il est préférable que le courant d'obscurité soit sensiblement identique pour toutes les cellules photosensibles du capteur d'image pour que les signaux mesurés aux noeuds de lecture, en particulier en cas de faible éclairement, aient une amplitude sensiblement uniforme. Il est donc souhaitable que le substrat dans lequel sont formées les photodiodes des cellules photosensibles soit maintenu à une température la plus uniforme possible, et si possible, à une température qui reste modérée.

Lorsque le capteur d'images est éclairé par la face avant, le substrat dans lequel sont formés les composants électroniques du capteur d'image a généralement une épaisseur de plusieurs centaines de micromètres. Un tel substrat permet une bonne évacuation de la chaleur fournie par les circuits à forte dissipation thermique. En outre, le substrat est généralement disposé au niveau d'un boîtier thermiquement conducteur facilitant encore davantage l'évacuation de la chaleur. De ce fait, la température du substrat reste sensiblement uniforme ce qui permet de conserver un courant d'obscurité, lorsqu'il est présent, relativement constant sur l'ensemble des cellules photosensibles.

Une difficulté apparaît lorsque le capteur d'images est éclairé par la face arrière dans la mesure où le substrat 14 a alors une faible épaisseur, par exemple de l'ordre de quelques micromètres et est thermiquement isolée. Il est alors difficile d'évacuer la chaleur fournie par les circuits périphériques à forte dissipation thermique. Ceci se traduit par des variations locales de la température pouvant entraîner une augmentation locale du courant d'obscurité.

Le document EP 1 653 515 décrit un capteur d'images éclairé par la face arrière comprenant deux puces de circuit intégré reliées par un radiateur.

### Résumé de l'invention

La présente invention vise un capteur d'images éclairé par la face arrière et comportant des circuits à forte dissipation thermique qui permet de maintenir le substrat au niveau duquel sont formés les composants électroniques du capteur d'images à une température sensiblement uniforme.

Selon un autre objet de la présente invention, le capteur d'images est susceptible d'être réalisé par un procédé compatible avec les technologies CMOS.

La présente invention vise également un procédé de fabrication d'un capteur d'images éclairé par la face arrière et comportant des circuits à forte dissipation thermique qui permet de maintenir le substrat au niveau duquel sont formés les composants électroniques du capteur d'images à une température sensiblement uniforme.

La présente invention prévoit un capteur d'images comme définit dans la revendication 1

Selon un exemple de réalisation de la présente invention, la couche comprend, en outre, du côté de la première face, des régions supplémentaires correspondant aux photodiodes.

Selon un exemple de réalisation de la présente invention, les régions sont disposées à la périphérie des régions supplémentaires.

Selon un exemple de réalisation de la présente invention, les vias sont réalisés au moins au niveau desdites régions.

Selon la présente invention, l'épaisseur de la couche est inférieure à 5 µm.

Selon un exemple de réalisation de la présente invention, le capteur d'images comprend, en outre, une couche supplémentaire d'un matériau semiconducteur ayant des troisième et quatrième faces opposées et comprenant, du côté de la troisième face, des régions supplémentaires correspondant aux photodiodes, la couche supplémentaire étant destinée à être éclairée par la quatrième face ; et un empilement supplémentaire de couches isolantes interposé entre la troisième face de la couche supplémentaire et la deuxième face de la couche.

Selon un exemple de réalisation de la présente invention, le capteur d'images comprend, en outre, au moins une portion isolante dans la couche ; au moins un via électriquement conducteur traversant la portion isolante et reliant une première piste électriquement conductrice disposée dans l'empilement et une seconde piste électriquement conductrice disposée dans l'empilement supplémentaire.

Un autre aspect de la présente invention prévoit un procédé de fabrication d'un capteur d'images comme décrit dans la revendication 7.

Selon un exemple de réalisation de la présente invention, le procédé comprend, en outre, l'étape consistant à former dans la couche, du côté de la première face, des régions supplémentaires correspondant aux photodiodes.

Selon un exemple de réalisation de la présente invention, le procédé comprend, en outre, les étapes préalables consistant à former une couche supplémentaire d'un matériau semiconducteur comportant des troisième et quatrième faces opposées, la couche supplémentaire étant destinée à être éclairée par la quatrième face ; à former, dans la couche supplémentaire, du côté de la troisième face, des régions supplémentaires correspondant aux photodiodes ; et à recouvrir la troisième face d'un empilement supplémentaire de couches isolantes, ladite couche recouvrant, du côté de la deuxième face, l'empilement supplémentaire.

### Brève description des dessins

Ces objets, caractéristiques et avantages, ainsi que d'autres de la présente invention seront exposés en détail dans la description suivante d'exemples de réalisation particuliers faite à titre non-limitatif en relation avec les figures jointes parmi lesquelles :
la figure 1, précédemment décrite, représente un schéma électrique d'une cellule photosensible ;
la figure 2, précédemment décrite, représente un exemple de répartition des composants du capteur d'images réalisé sous forme monolithique ;
la figure 3, précédemment décrite, représente un exemple de réalisation classique sous forme monolithique d'un capteur d'images éclairé par la face arrière ;
les figures 4A à 4E illustrent les étapes successives d'un exemple de procédé de fabrication d'un premier exemple de réalisation d'un capteur d'images éclairé par la face arrière selon l'invention ;
les figures 5A à 5F illustrent les étapes successives d'un exemple de procédé de fabrication d'un second exemple de réalisation d'un capteur d'images éclairé par la face arrière selon l'invention ; et
la figure 6 représente, de façon schématique, un téléphone portable comprenant un capteur d'images selon l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Un aspect de la présente invention consiste, pour un capteur d'images éclairé par la face arrière, à évacuer la chaleur émise par les circuits à forte dissipation thermique vers le renfort du capteur d'images au travers de l'empilement de couches isolantes séparant le substrat du renfort. Selon un autre aspect de l'invention, le renfort utilisé pour l'évacuation de la chaleur émise par les circuits à forte dissipation thermique constitue l'unique renfort structurel du capteur d'images. Selon un exemple de réalisation, le renfort a une épaisseur supérieure à 200 µm. Selon un autre aspect de l'invention, les photodiodes sont disposées du même côté du renfort que les transistors des circuits à forte dissipation thermique.

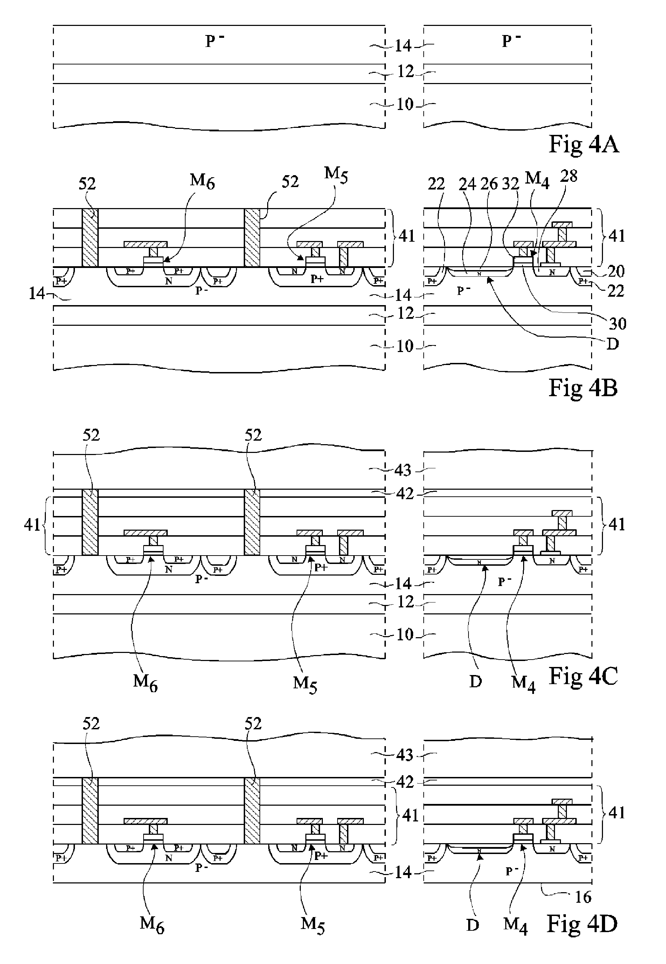

Les figures 4A à 4E illustrent un exemple de procédé de fabrication d'un premier exemple de réalisation d'un capteur d'images éclairé par la face arrière selon l'invention. Les éléments communs à la figure 3 ont été désignés par de mêmes références.

La figure 4A représente un support 10 de silicium massif recouvert d'une couche isolante 12, par exemple un oxyde thermique. Le substrat 14 est formé sur la couche isolante 12 éventuellement avec interposition d'une couche d'amorce. Le substrat 14 a une épaisseur de quelques micromètres, de préférence inférieure à 5 µm. Une telle structure correspond à une structure SOI (acronyme anglais pour Silicon On Insulator).

La figure 4B représente la structure obtenue après avoir formé la totalité des composants électroniques des cellules photosensibles et des circuits périphériques, ainsi que l'empilement 41 de couches isolantes, les pistes métalliques 44 et les vias 46. Pour chaque cellule photosensible, bien que seuls la photodiode D et le transistor M₄ soient représentés en figure 4B, les autres transistors de la cellule, à savoir les transistors M1, M2 et M3, sont également formés au niveau du substrat 14. Le premier exemple de réalisation selon l'invention prévoit de réaliser au niveau des circuits périphériques des vias 52 traversant la totalité de l'empilement de couches isolantes 41 et dont une extrémité est au contact du substrat 14. Les vias 52 peuvent être prévus uniquement au niveau des circuits périphériques à forte dissipation thermique ou au niveau de la totalité des circuits périphériques. La densité des vias 52 au niveau des circuits périphériques à forte dissipation thermique pouvant éventuellement être plus élevée que pour les autres circuits périphériques. Les vias 52 sont réalisés en un matériau qui est un bon conducteur de la chaleur mais pas nécessairement un bon conducteur électrique. A titre d'exemple, les vias 52 peuvent être réalisés en cuivre ou en nitrure d'aluminium (AlN).

La figure 4C représente la structure obtenue après avoir collé, sur la face supérieure de l'empilement de couches isolantes 41, un élément de renfort constitué, par exemple, de l'empilement de la couche isolante 42 et du renfort en silicium 43, les vias 52 étant prolongés au travers de la couche isolante 42 pour venir au contact du renfort en silicium 43. Le renfort 43 peut avoir une épaisseur de plusieurs centaines de micromètres.

La figure 4D représente la structure obtenue après une étape "d'amincissement" qui consiste à retirer, par exemple par une attaque chimique ou mécanochimique, le support 10 et la couche isolante 12 de façon à exposer la face inférieure 16 du substrat 14. Le support 10 et la couche isolante 12 peuvent être retirés par gravure, l'arrêt de gravure pouvant être obtenu en jouant sur les différences de sélectivité entre la couche isolante 12 et le substrat 14. Selon une variante de réalisation, le substrat 14 correspond à une couche de silicium de type P faiblement dopée réalisée par épitaxie sur un support de silicium massif de type P plus fortement dopé. Dans ce cas, l'étape d'amincissement consiste à retirer le support de silicium, par exemple par gravure, l'arrêt de gravure pouvant être obtenu en jouant sur les différences de sélectivité entre la couche épitaxiée 14 et le support.

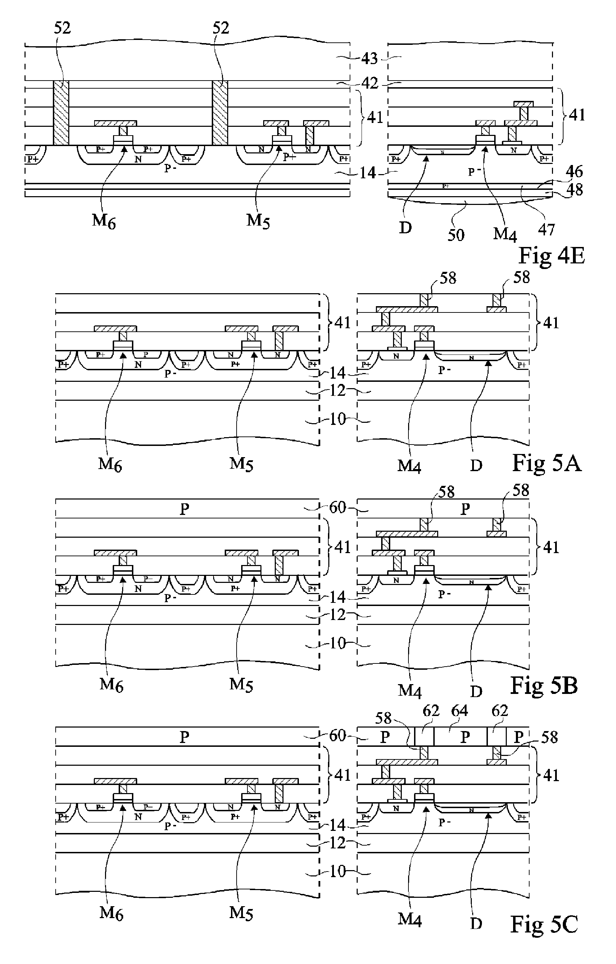

La figure 4E représente la structure obtenue après avoir formé la région 44 de type P plus fortement dopée que le substrat 14 du côté de la face arrière 16 et après avoir formé, sur la face arrière 16, les filtres colorés 48 et les lentilles 50 associés aux cellules photosensibles du capteur d'images et la couche isolante 52 au niveau des circuits périphériques. La région 44 peut être réalisée par une implantation au niveau de la face arrière 16 du substrat 14 suivie d'un recuit d'activation.

Le premier exemple de capteur d'images selon l'invention présente l'avantage, en fonctionnement, que la chaleur fournie par les circuits périphériques à forte dissipation thermique est évacuée, par l'intermédiaire des vias 52, jusqu'au renfort 43 permettant ainsi le maintien du substrat 14 à une température sensiblement uniforme. En outre, le renfort 43 peut lui-même être fixé sur un boîtier conducteur pour améliorer encore davantage l'évacuation de la chaleur.

Les figures 5A à 5F illustrent les étapes d'un exemple de procédé de fabrication d'un second exemple de réalisation d'un capteur d'images éclairé par la face arrière selon l'invention.

La figure 5A illustre la structure obtenue après des étapes analogues à celles qui ont été précédemment décrites pour le procédé de fabrication du premier exemple de réalisation du capteur d'images selon l'invention en relation aux figures 4A et 4B. Toutefois, à la différence de ce qui a été précédemment décrit, on ne réalise, pour chaque cellule photosensible, que la photodiode D et le transistor de transfert M₄. Côté circuits périphériques, seuls sont réalisés les composants ne présentant pas une forte dissipation thermique. En outre, les vias 52 ne sont pas réalisés. De plus, on prévoit des vias 58 qui s'étendent jusqu'à la face supérieure de l'empilement 41 de couches isolantes.

La figure 5B représente la structure obtenue après avoir formé sur l'empilement de couches isolantes 41 une couche 60 de silicium monocristallin de type P, éventuellement plus fortement dopée que le substrat 14. L'épaisseur de la couche 60 peut varier d'une vingtaine de nanomètres à quelques micromètres, et est inférieure à 5 µm. De façon générale, la couche 60 peut être très mince puisque la fonction d'absorption de la lumière atteignant le capteur d'images n'est pas remplie par cette couche 60. La couche 60 peut être réalisée en déposant du silicium amorphe sur l'empilement de couches isolantes 41 et en réalisant une étape de recristallisation de la couche de silicium amorphe par un procédé n'entraînant pas une élévation trop importante de la température du reste du capteur d'images, en particulier de l'empilement de couches isolantes 41. En effet, une élévation excessive de la température de l'empilement 41 peut entraîner une détérioration des matériaux utilisés pour la réalisation des couches isolantes 41 et des pistes et vias conducteurs 44, 46. A titre d'exemple, lorsque les pistes métalliques 44 sont réalisées en cuivre, la température de l'empilement 41 ne devrait pas excéder 400°C. Pour ce faire, la recristallisation de la couche de silicium amorphe peut être obtenue par un chauffage global du capteur d'images à faible température ou par un chauffage localisé de la couche de silicium amorphe, par exemple par l'intermédiaire d'un laser.

La figure 5C représente la structure obtenue après avoir formé dans la couche 60 des portions isolantes 62 aboutissant à la formation d'îlots 64 dans la couche isolante 60. A titre d'exemple, les portions isolantes 62 peuvent être obtenues en gravant la couche 60 sur toute son épaisseur et en remplissant les ouvertures obtenues par un matériau isolant, par exemple de l'oxyde de silicium. Les portions isolantes 62 recouvrent les extrémités des vias 58. Selon une variante du second exemple de réalisation, les portions isolantes 62 correspondent aux ouvertures pratiquées dans la couche 60 qui sont laissées telles quelles.

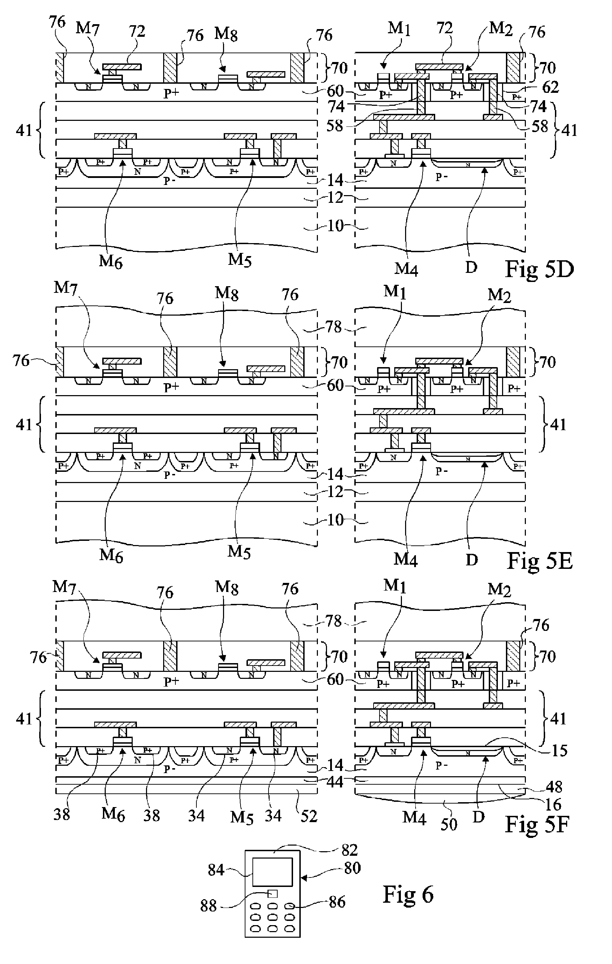

La figure 5D représente la structure obtenue après avoir formé des transistors MOS au niveau de la couche 60 et après avoir recouvert la couche 60 d'un empilement de couches isolantes 70. A titre d'exemple, on a représenté, côté cellules photosensibles, les transistors MOS M₁ et M₂, et côté circuits périphériques, deux transistors MOS M₇ et M₈. De façon générale, côté cellules photosensibles, on réalise, pour chaque cellule photosensible, tous les transistors de la cellule photosensible autres que le transistor de transfert M₄, et côté circuits périphériques, on réalise tous les composants qui n'ont pas déjà été formés au niveau du substrat 14, c'est-à-dire notamment les composants des circuits périphériques à forte dissipation thermique.

Les procédés de fabrication des transistors M₁, M₂, M₇, M₈ sont adaptés à ne pas entraîner une élévation excessive de la température du reste du capteur d'images. A titre d'exemple, on peut utiliser pour réaliser les grilles des transistors, des matériaux à fort coefficient diélectrique, par exemple de l'oxyde d'Hafnium, qui peuvent être déposés par des procédés à faible température, ou utiliser des matériaux isolants classiques qui sont alors déposés à faible température, par exemple par des procédés au plasma. En outre, les grilles des transistors peuvent être réalisées par le dépôt d'un matériau à base de nitrure de titane TiN par un procédé de dépôt de couche atomique ou procédé ALD (pour Atomic Layer Deposition) ou par un dépôt chimique en phase vapeur ou procédé CVD (pour Chemical Vapour Deposition). Des pistes conductrices et vias conducteurs 72 assurant l'interconnexion des transistors sont formés au niveau de l'empilement de couches isolantes 70. En particulier, des vias 74 sont formés au niveau des portions isolantes 62 pour venir au contact des vias 58 prévus au niveau de l'empilement de couches isolantes 41. En outre, on prévoit des vias de drainage thermique 76 qui traversent la totalité de l'empilement de couches isolantes 70 et viennent en contact à une extrémité avec la couche semiconductrice 60. Les vias 76 peuvent être réalisés au niveau de la totalité de la couche 60, éventuellement en augmentant la densité de vias 76 à proximité des circuits périphériques à forte dissipation thermique. Selon une variante, les vias 76 peuvent être réalisés seulement au niveau de la totalité des circuits périphériques réalisés au niveau de la couche 60, ou seulement au niveau des circuits périphériques à forte dissipation thermique. Les vias 76 sont constitués d'un matériau bon conducteur de la chaleur mais pas nécessairement bon conducteur électrique.

La figure 5E représente la structure obtenue après avoir recouvert l'empilement de couches isolantes 70 d'un renfort 78 d'un matériau thermiquement conducteur, par exemple une plaquette de silicium massif. Le renfort 78 peut avoir une épaisseur de plusieurs centaines de micromètres. Les vias 76 viennent au contact du renfort 78.

La figure 5F représente la structure obtenue après avoir réalisé l'étape d'amincissement décrite précédemment pour le procédé de fabrication du premier exemple de réalisation du capteur d'images selon l'invention en relation à la figure 4D et après avoir formé les filtres 48, les lentilles 50 et la couche isolante 52 comme cela a été décrit précédemment pour le procédé de fabrication du premier exemple de réalisation du capteur d'images selon l'invention en relation à la figure 4E.

En fonctionnement, la chaleur produite par les composants formés dans la couche 60 des circuits périphériques à forte dissipation thermique est évacuée jusqu'au renfort 78 par l'intermédiaire des vias 76. En outre, le renfort 78 peut être fixé à un boîtier thermiquement conducteur améliorant encore davantage l'évacuation de chaleur. Comme les circuits à forte dissipation thermique ne sont pas présents au niveau du substrat 14, la température du substrat 14 reste sensiblement uniforme.

La figure 6 illustre un exemple d'utilisation du capteur d'images selon l'invention. La figure 6 représente, de façon très schématique, un téléphone portable 80 comprenant un boîtier 82 au niveau duquel sont disposés un écran 84 et un clavier 86. Le téléphone portable 80 comprend également un système d'acquisition d'images 88 comportant un système optique dirigeant les rayons lumineux vers un capteur d'images selon l'invention.

Bien entendu, la présente invention est susceptible de diverses variantes et modifications qui apparaîtront à l'homme de l'art. En particulier, la présente invention s'applique également à une cellule photosensible pour laquelle plusieurs photodiodes sont reliées à un même noeud de lecture. En outre, bien que la présente invention ait été décrite pour une cellule de capteurs d'images dans laquelle le dispositif de précharge et le dispositif de lecture ont une structure particulière, la présente invention s'applique également à une cellule pour laquelle le dispositif de précharge ou le dispositif de lecture ont une structure différente, par exemple comprennent un nombre différent de transistors MOS.

## Revendications

1. Capteur d'images éclairé par la face arrière comprenant des cellules photosensibles comportant des photodiodes (D) et au moins un circuit supplémentaire à forte dissipation thermique comportant des transistors (M₅, M₆ ; M₇, M₈), étant réalisé de façon monolithique et comprenant :
une couche (14 ; 60) d'un matériau semiconducteur ayant une épaisseur inférieure à 5 µm et des première et deuxième faces opposées (15, 16) et comprenant, du côté de la première face (15), des régions (34, 38) correspondant aux bornes de puissance des transistors, l'éclairage du capteur d'images étant destiné à être réalisé du côté de la deuxième face ;
un empilement de couches isolantes (41 ; 70) recouvrant la première face ;
**caractérisé par** un renfort (43 ; 78) unique thermiquement conducteur, ayant une épaisseur supérieure à 200 µm et recouvrant l'empilement du côté opposé à la couche d'un matériau semiconducteur, les photodiodes étant disposées du même côté du renfort que les transistors ; et
des vias (52 ; 76) thermiquement conducteurs reliant la couche au renfort.

2. Capteur d'images selon la revendication 1, dans lequel la couche d'un matériau semiconducteur (14) comprend, en outre, du côté de la première face (15), des régions supplémentaires (24, 26) correspondant aux photodiodes (D).

3. Capteur d'images selon la revendication 2, dans lequel les régions correspondant aux bornes de puissance des transistors (34, 38) sont disposées à la périphérie des régions supplémentaires (24, 26).

4. Capteur d'images selon la revendication 1, dans lequel les vias (52 ; 76) sont réalisés au moins au niveau desdites régions (34, 38).

5. Capteur d'images selon la revendication 1, comprenant, en outre :
une couche supplémentaire (14) d'un matériau semiconducteur ayant des troisième et quatrième faces opposées (15, 16) et comprenant, du côté de la troisième face (15), des régions supplémentaires (24, 26) correspondant aux photodiodes (D), la couche supplémentaire étant destinée à être éclairée par la quatrième face (16) ; et
un empilement supplémentaire (41) de couches isolantes interposé entre la troisième face de la couche supplémentaire et la deuxième face de la couche d'un matériau semiconducteur (60).

6. Capteur d'images selon la revendication 5, comprenant, en outre :
au moins une portion isolante (62) dans la couche d'un matériau semiconducteur (60) ;
au moins un via électriquement conducteur (78) traversant la portion isolante et reliant une première piste électriquement conductrice disposée dans l'empilement (70) et une seconde piste électriquement conductrice (44) disposée dans l'empilement supplémentaire (41).

7. Procédé de fabrication d'un capteur d'images comprenant des cellules photosensibles comportant des photodiodes (D) et au moins un circuit périphérique à forte dissipation thermique comportant des transistors (M₅, M₆ ; M₇, M₈), **caractérisé en ce qu'**il comprend les étapes suivantes :
former une couche (14 ; 60) d'un matériau semiconducteur ayant une épaisseur inférieure à 5 µm et des première et deuxième faces opposées (15, 16), l'éclairage du capteur étant destiné à être réalisé du côté de la deuxième face (16) ;
former dans la couche, du côté de la première face (15), des régions (34, 38) correspondant aux bornes de puissance des transistors ;
recouvrir la première face (15) d'un empilement de couches isolantes (41 ; 70) et former, dans l'empilement, des vias thermiquement conducteurs (52 ; 76) ; et
recouvrir l'empilement d'un renfort (43 ; 78) unique thermiquement conducteur ayant une épaisseur supérieure à 200 µm, les photodiodes étant disposées du même côté du renfort que les transistors, les vias reliant la couche d'un matériau semiconducteur au renfort.

8. Procédé selon la revendication 7, comprenant, en outre, l'étape consistant à former dans la couche d'un matériau semiconducteur (14), du côté de la première face (15), des régions supplémentaires (24, 26) correspondant aux photodiodes (D).

9. Procédé selon la revendication 7, comprenant, en outre, les étapes préalables suivantes :
former une couche supplémentaire (14) d'un matériau semiconducteur comportant des troisième et quatrième faces opposées (15, 16), la couche supplémentaire étant destinée à être éclairée par la quatrième face (16) ;
former, dans la couche supplémentaire, du côté de la troisième face (15), des régions supplémentaires (24, 26) correspondant aux photodiodes (D) ; et
recouvrir la troisième face d'un empilement supplémentaire (41) de couches isolantes, ladite couche d'un matériau semiconducteur (60) recouvrant, du côté de la deuxième face, l'empilement supplémentaire.

## Patentansprüche

1. Ein Rückseiten-Bildsensor der fotoempfindliche Zellen aufweist, die Fotodioden (D) und mindestens eine zusätzliche Schaltung mit einer starken Wärmeverteilung aufweisen, die Transistoren (M₅, M₆, M₇, M₈) hergestellt in monolithischer Form umfasst, wobei folgendes vorgesehen ist:
eine Schicht (14; 60) aus einem Halbleitermaterial mit einer Dicke kleiner als 5 µm und ersten und zweiten entgegengesetzt liegenden Oberflächen (15, 16) und zwar aufweisend auf einer ersten Oberflächenseite (15) Zonen (34, 38) entsprechend den Leistungsanschlüssen der Transistoren, wobei die Belichtung des Bildsensors auf einer zweiten Oberflächenseite ausgeführt werden soll;
ein Stapel von Isolierschichten (41; 70), die die erste Oberfläche abdecken;
**gekennzeichnet durch**:
eine einzige thermisch leitende Verstärkung (43; 78) mit einer Dicke, die größer ist als 200 µm und den Stapel auf der Seite entgegengesetzt zu der erwähnten Halbleitermaterialschicht abdeckt, wobei die Fotodioden auf der gleichen Seite der Verstärkung angeordnet sind wie die Transistoren; und
thermisch leitende Vias (52; 76), die die Schicht mit der Verstärkung verbinden.

2. Der Bildsensor nach Anspruch 1, wobei die Halbleitermaterialschicht (14) ferner auf der ersten Oberflächenseite (15) zusätzliche Zonen (24, 26) aufweist, die den Fotodioden (D) entsprechen.

3. Der Bildsensor nach Anspruch 2, wobei die Zonen, die dem Leistungsanschluss der Transistoren (34, 38) entsprechen am Umfang der zusätzlichen Zonen (24, 26) angeordnet sind.

4. Der Bildsensor nach Anspruch 1, wobei die erwähnten Vias (52; 76) mindestens auf dem Niveau der Zonen (34, 38) geformt sind.

5. Der Bildsensor nach Anspruch 1, wobei ferner folgendes vorgesehen ist:
eine zusätzliche Schicht (14) aus Halbleitermaterial mit dritten und vierten entgegengesetzt liegenden Oberflächen (15, 16) und zwar aufweisend auf der dritten Oberflächenseite (15) zusätzliche Zonen (24, 26) entsprechend den Fotodioden D, wobei die zusätzliche Schicht vorgesehen ist um auf ihrer vierten Oberfläche (16) beleuchtet zu werden; und
ein zusätzlicher Stapel (41) von Isolierschichten angeordnet zwischen der dritten Oberfläche der zusätzlichen Schicht und der zweiten Oberfläche der erwähnten Schicht (60).

6. Der Bildsensor nach Anspruch 5, wobei ferner folgendes vorgesehen ist:
mindestens ein Isolierteil (62) in der Halbleitermaterialschicht (60);
mindestens eine elektrisch leitende Via (78), die den Isolierteil kreuzt und eine erste elektrisch leitende Bahn angeordnet in dem Stapel (70) und eine zweite elektrisch leitende Bahn (44) angeordnet in dem zusätzlichen Stapel (41), verbindet.

7. Ein Verfahren zur Herstellung eines Bildsensors, der fotoempfindliche Zellen aufweist, die Fotodioden (D) aufweisen und mindestens eine Umfangsschaltung mit einer starken Wärmeableitung und zwar Transistoren (M₅, M₆, M₇, M₈) aufweisend, wobei das Verfahren die folgenden Schritte vorsieht:
Formen einer Schicht (14; 60) aus einem Halbleitermaterial mit einer Dicke kleiner als 5 µm und ersten und zweiten entgegengesetzt liegenden Oberflächen (15, 16), wobei die Beleuchtung des Sensors zur Durchführung auf der zweiten Oberflächenseite (16) vorgesehen ist;
Formen in der erwähnten Schicht auf der ersten Oberflächenseite (15) Zonen (34, 38) entsprechend den Leistungsanschlüssen der Transistoren;
Abdecken der ersten Oberfläche (15) mit einem Stapel aus isolierenden Schichten (41; 70) und Formen thermisch leitender Vias (52; 76) in dem Stapel; und
Abdecken des Stapels mit einer einzigen thermisch leitenden Verstärkung (43; 78) mit einer Dicke größer als 200 µm, wobei die Fotodioden auf der gleichen Seite wie der Transistor angeordnet sind, wobei die Vias die erwähnten Halbleitermaterialschichten mit der Verstärkung verbinden.

8. Das Verfahren nach Anspruch 7, wobei ferner der Schritt des Formens in der Halbleitermaterialschicht (14) auf der ersten Oberflächenseite (15) zusätzlicher Regionen (24, 26) entsprechend den Fotodioden (D) vorgesehen ist.

9. Das Verfahren nach Anspruch 7, wobei ferner die vorherigen Schritte vorgesehen sind, nämlich:
Formen einer zusätzlichen Schicht (14) aus einem Halbleitermaterial welches dritte und vierte entgegengesetzt liegende Oberflächen (15, 16) aufweist, wobei die zusätzliche Schicht vorgesehen ist, um auf Ihrer vierten Oberfläche (16) beleuchtet zu werden;
Formen in der zusätzlichen Schicht auf der dritten Oberflächenseite (15) zusätzliche Zonen (24, 26) entsprechend den Fotodioden D; und
Abdecken der dritten Oberfläche mit einem zusätzlichen Stapel (41) von Isolierschichten, wobei die Halbleitermaterialschicht (60) den zusätzlichen Stapel auf der zweiten Oberflächenseite abdeckt.

## Claims

1. A backside image sensor comprising photosensitive cells comprising photodiodes (D) and at least one additional circuit with a strong heat dissipation comprising transistors (M₅, M₆; M₇, M₈), made in monolithic form and comprising:
a layer (14; 60) of a semiconductor material having a thickness smaller than 5 µm and first and second opposite surfaces (15, 16) and comprising, on a first surface side (15), regions (34, 38) corresponding to power terminals of the transistors, the lighting of the image sensor being intended to be performed on a second surface side;
a stack of insulating layers (41; 70) covering said first surface;
**characterized by**:
a single thermally conductive reinforcement (43; 78), having a thickness greater than 200 µm and covering the stack on the side opposite to said semiconductor material layer, the photodiodes being disposed on the same side of the reinforcement as the transistors; and
thermally conductive vias (52; 76) connecting said layer to the reinforcement.

2. The image sensor of claim 1, wherein said semiconductor material layer (14) further comprises, on the first surface side (15), additional regions (24, 26) corresponding to the photodiodes (D).

3. The image sensor of claim 2, wherein the regions corresponding to the power terminal of the transistors (34, 38) are arranged at the periphery of the additional regions (24, 26).

4. The image sensor of claim 1, wherein said vias (52; 76) are formed at least at the level of said regions (34, 38).

5. The image sensor of claim 1, further comprising:
an additional layer (14) of a semiconductor material having third and fourth opposite surfaces (15, 16) and comprising, on the third surface side (15), additional regions (24, 26) corresponding to the photodiodes (D), the additional layer being intended to be lit on its fourth surface (16); and
an additional stack (41) of insulating layers interposed between the third surface of the additional layer and the second surface of said layer (60).

6. The image sensor of claim 5, further comprising:
at least one insulating portion (62) in the semiconductor material layer (60);
at least one electrically-conductive via (78) crossing the insulating portion and connecting a first electrically-conductive track arranged in the stack (70) and a second electrically-conductive track (44) arranged in the additional stack (41).

7. A method for manufacturing an image sensor comprising photosensitive cells comprising photodiodes (D) and at least one peripheral circuit with a strong heat dissipation comprising transistors (M₅, M₆; M₇, M₈), comprising the steps of:
forming a layer (14; 60) of a semiconductor material having a thickness smaller than 5 µm and first and second opposite surfaces (15, 16), the lighting of the sensor being intended to be performed on the second surface side (16);
forming in said layer, on the first surface side (15), regions (34, 38) corresponding to power terminals of the transistors;
covering the first surface (15) with a stack of insulating layers (41; 70) and forming, in the stack, thermally-conductive vias (52; 76); and
covering the stack with a single thermally-conductive reinforcement (43; 78), having a thickness greater than 200 µm, the photodiodes being disposed on the same side of the reinforcement as the transistor, said vias connecting said semiconductive material layer to the reinforcement.

8. The method of claim 7, further comprising the step of forming in the semiconductive material layer (14), on the first surface side (15), additional regions (24, 26) corresponding to the photodiodes (D).

9. The method of claim 7, further comprising the previous steps of:
forming an additional layer (14) of a semiconductor material comprising third and fourth opposite surfaces (15, 16), the additional layer being intended to be lit on its fourth surface (16) ;
forming, in the additional layer, on the third surface side (15), additional regions (24, 26) corresponding to the photodiodes (D); and
covering the third surface with an additional stack (41) of insulating layers, said semiconductive material layer (60) covering, on the second surface side, the additional stack.
